(19) Europäisches Patentamt
European Patent Office
Office européen des brevets

(11) **EP 4 250 009 A1**

(12) **EUROPEAN PATENT APPLICATION**

(43) Date of publication:
**27.09.2023 Bulletin 2023/39**

(51) International Patent Classification (IPC):
*G03F 7/20* $^{(2006.01)}$

(21) Application number: **22163435.5**

(52) Cooperative Patent Classification (CPC):
**G03F 7/70525; G03F 7/70458; G03F 7/70516**

(22) Date of filing: **22.03.2022**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **HAUPTMANN, Marc**
**5500 AH Veldhoven (NL)**

• **MEIJERINK, Rick, Jeroen**
**5500 AH Veldhoven (NL)**
• **ZENG, Si-Han**
**5500 AH Veldhoven (NL)**
• **BAO, Jiazi**
**5500 AH Veldhoven (NL)**

(74) Representative: **ASML Netherlands B.V.**
**Corporate Intellectual Property**
**P.O. Box 324**
**5500 AH Veldhoven (NL)**

(54) **SETUP AND CONTROL METHODS FOR A LITHOGRAPHIC PROCESS AND ASSOCIATED APPARATUSES**

(57) Disclosed is a method for performing a lithographic apparatus setup calibration and/or drift correction for a specific lithographic apparatus of a population of lithographic apparatuses to be used in a manufacturing process for manufacturing an integrated circuit extending across a plurality of layers on a substrate. The method comprises determining a spatial error distribution of an apparatus parameter across spatial coordinates on the substrate for each lithographic apparatus of the population of lithographic apparatuses and/or each layer of the plurality of layers; determining a reference distribution by aggregating each of the spatial error distributions to optimize the reference distribution such that a spatial distribution of a parameter of interest of the manufacturing process is co-optimized across the population of lithographic apparatuses and/or plurality of layers; and using the reference distribution as a target distribution for the apparatus parameter for each lithographic apparatus and/or layer.

Fig. 3

EP 4 250 009 A1

## Description

BACKGROUND

Field of the Invention

The present invention relates to methods and apparatus usable, for example, in the manufacture of devices by lithographic techniques, and to methods of manufacturing devices using lithographic techniques.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

The lithographic apparatus comprises a projection system. The projection system comprises optical elements such as, for example, lenses. Optical aberrations may arise from imperfections in the optical elements. Optical aberrations may also arise from projection effects such as, for example, the heating of optical elements that occurs during a lithographic exposure. Projection system models are used to determine one or more adjustments that may be made to the optical elements of the projection system. The determined adjustments may have the effect of reducing optical aberrations within the projection system.

It may be desirable to provide, for example, to improve on aspects of calibration, setup and control (e.g., drift control) of a lithographic process, for example for set up of a projection system or a grid set up, which obviates or mitigates one or more of the problems of the prior art, whether identified herein or elsewhere.

SUMMARY OF THE INVENTION

The invention in a first aspect provides a method for performing a lithographic apparatus setup calibration and/or drift correction for a specific lithographic apparatus of a population of lithographic apparatuses to be used in a manufacturing process for manufacturing an integrated circuit extending across a plurality of layers on a substrate, the method comprising: determining a spatial error distribution of an apparatus parameter across spatial coordinates on the substrate for each lithographic apparatus of said population of lithographic apparatuses and/or each layer of the plurality of layers; determining a reference distribution by aggregating each of said spatial error distributions to optimize said reference distribution such that a spatial distribution of a parameter of interest of said manufacturing process is co-optimized across said population of lithographic apparatuses and/or plurality of layers; and using said reference distribution as a target distribution for said apparatus parameter for each lithographic apparatus and/or layer.

In a second aspect of the invention there is provided a computer program comprising program instructions operable to perform the method of any preceding claim, when run on a suitable apparatus.

The invention yet further provides a processing arrangement and lithographic apparatus comprising the computer program of the second aspect.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying drawings, in which:

> Figure 1 depicts a lithographic apparatus;
> Figure 2 illustrates schematically measurement and exposure processes in the apparatus of Figure 1; and
> Figure 3 is a flow chart of a method according to an embodiment of the invention.

DETAILED DESCRIPTION OF EMBODIMENTS

Before describing embodiments of the invention in detail, it is instructive to present an example environment in which embodiments of the present invention may be implemented.

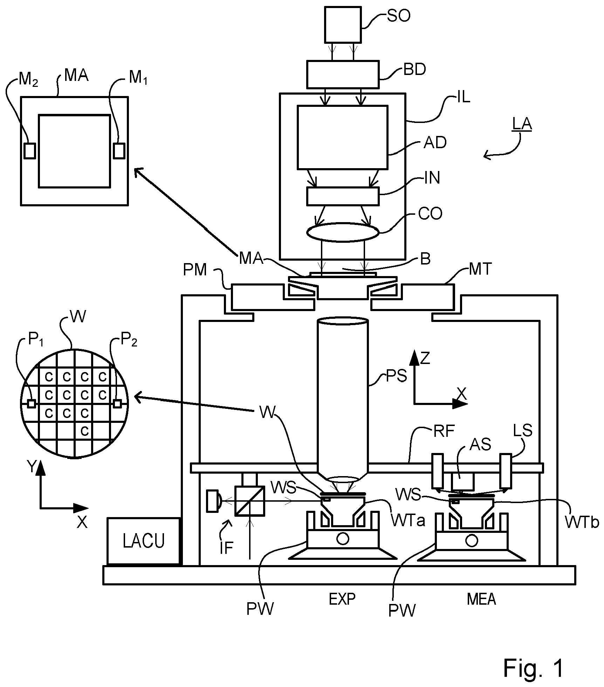

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The lithographic apparatus LA further comprises a wavefront sensor WS; e.g., on each substrate table WTa, WTb. Such a sensor may measure the quality of the wavefront image, as well as any aberrations and therefore enable (e.g., parallel) measurement of optical aberrations throughout the projection slit, thus enabling, for example, a more accurate alignment, improved reticle heating correction and on the fly lens heating correction. Such aberrations may be described as coefficients in a series of 2D mathematical functions called Zernike polynomials. These can be regrouped to describe some well-known optical aberrations, such as spherical, coma, and astigmatism. The wavefront sensor may comprise an interferometric wavefront measurement system and may perform static measurements on lens aberrations up to high order. It may be implemented as an integrated measurement system used for system initialization and calibration. Alternatively, it may be used for monitoring and recalibration "on-demand". As such, the wavefront sensor may be able to measure the lens aberrations on a per lot or per-wafer basis depending on its design.

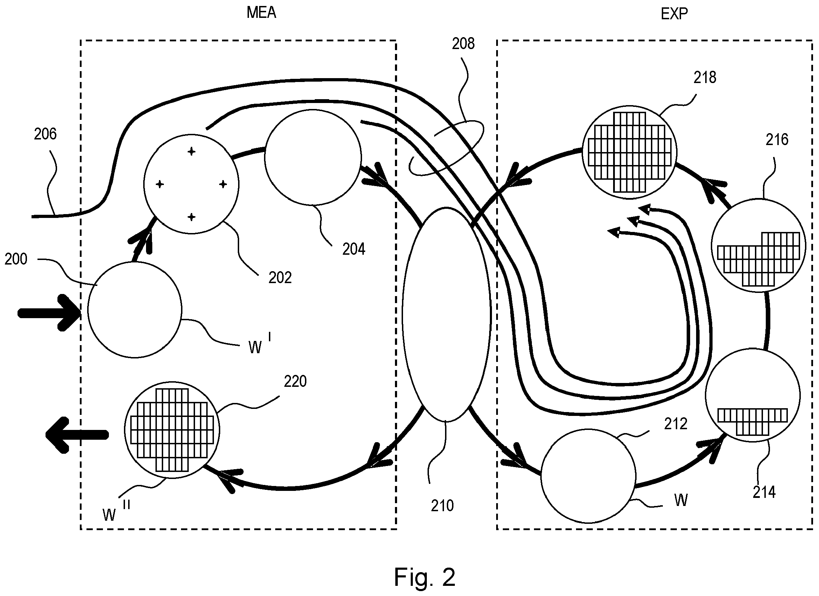

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

Prior to using a lithographic apparatus or scanner, a number of setup or calibration operations should be performed. One such setup operation comprises lens setup. The goal of lens setup is to optimize the lens aberrations within the lithographic system: e.g., to a target which may be zero. The lens quality and lens setup optimization determines, for a given system, how well the target is achieved. Every lens has a different spatial distribution of lens aberration values across its exposure field, normally referred to as the lens fingerprint (LFP), thus the lens performance is not identical for all scanners within a certain facilility (fab), but has a population distribution. Lens setup may comprise minimizing the intrinsic lens fingerprints via actuation of lens elements (typically referred to a lens manipulators) to minimize the aberrations or lens fingerprint. The lens actuators can correct some of the lens fingerprint, but its actuation potential is limited and as such, even after setup there will be a minimized baseline fingerprint or a lens setup residual fingerprint.

The lens setup may be performed using a lens model which relates (setpoints of) the lens actuators to the aberrations and the lens fingerprint LFP. The aberrations may be described, for example, in terms of coefficients multiplied with Zernike polynomials such that the linear combination describes the aberrations (typically defined as a wavefront aberration across a pupil plane)of the lenses. The lens manipulators characteristics and aberration data, for example based on measurements (e.g., wavefront measurements using a wavefront sensor) are combined in the lens models. Lens models are used to adjust the lenses using manipulators to achieve the desired optical performance. More specifically, a calibration lens model (CLM) may be used during lens setup, which provides access to all possible lens actuators/manipulators. One or more other lens models may be used in a production setting, which may only provide access to a subset of these actuators. Lens setup is presently performed for each individual scanner in order to minimize the root mean square of the lens aberrations across an exposure field of the individual scanner. The different aberrations (Zernikes) are typically given equal or a nominal weight in the optimization, except for maybe the very high orders which may be weighted considerably less.

Another setup operation comprises grid setup. This may be performed, for example, as a calibration of a substrate table to determine a measure grid and/or an exposure grid. The description herein will be in the context of a twin stage scanner such as illustrated in Figure 1, where there is a measure grid on the measure size and expose grid on the exposure side. However, the concept of a grid setup is equally applicable to a single stage scanner where only a single exposure grid is determined. Alternatively the measure grid may relate to a separate, stand alone, measurement station.

On the measure side, scanner internal metrology (e.g. using alignment sensor and/or level sensor) is used to readout wafers with pre-existing marks to identify distortion of the measure grid. This is usually done for measure grid calibrations. On the exposure side, the method starts with a projection procedure in which patterns are exposed onto the substrate at various positions. Since the projection procedure is performed by each time positioning the substrate relative to an expose grid of the measurement system, deviations in this expose grid are automatically copied together with the pattern onto the substrate. Subsequently the calibration method includes the act of performing a measurement in which the projected pattern is read out. With this the position of the pattern on the substrate is measured relative to a scanner grid or measure grid. Deviations in this measure grid are thus automatically included in the measurement results. These deviations can be described by a scanner position deviation fingerprint or position deviation map. Grid setup may be performed using dedicated calibration substrates. An optimization may be performed similarly as with the lens setup, to manipulate the appropriate scanner actuators (mainly the stage actuators, though lens actuators may also be used), to minimize the position deviation fingerprint, e.g., by changing the reticle and/or wafer stage trajectory accordingly. Typically, as with lens set-up, this calibration is done individually per scanner to attempt to reduce the deviations to zero, although once again the degree to which this is achievable is limited by actuation capability.

After setup, the scanner is typically not stable, as components may drift leading to changes in lens fingerprints and/or position deviations. Scanner drift control aims at measuring and correcting these drifts with respect to the initial scanner setup at startup (T=0).

As such, these setup methods only take the individual scanner into account. However, it is increasingly common for different layers to be exposed on different physical scanners; sometimes these scanners comprising different scanner models or scanner types. For these machine-to-machine (M2M) matching applications (e.g., matched machine overlay (MMO) applications), lens fingerprints (LFPs) and/or position deviation fingerprint (or other fingerprints) that are individually and generally minimized might not yield the best results (e.g., lowest MMO) for the final product after exposure of the multiple layers. There are methods of addressing some of these issues during production; however it is desirable to provide a solution at scanner setup (and for control of drift), as this would relieve the logistical burden in managing subrecipes per layer per machine combination, and would not be subject to the more limited capabilities of e.g. the lens model used during production.

Furthermore, certain types of machines are used in specific application domains only (e.g., front end-of-line FEOL). This is not taken into account with present setup routines, and therefore the (e.g., lens) setup residuals might not reflect the actual optimum within that application domain. This might be exacerbated by the fact that certain layers in the application domain (with specific sensitivities) are often more critical than others (with their specific sensitivities) for overlay. Typically, different features may have different properties and therefore different sensitivities. By setting up each machine in isolation, the population of scanners, the scanner with respect to population or what each scanner is being used for is not taken into account.

To address these issues, it is proposed to perform a scanner (lithographic apparatus) setup correction and/or drift correction for a specific scanner of a population of scanners to be used in a manufacturing process for manufacturing an integrated circuit and/or layer extending across a plurality of layers comprised in said integrated circuit; the method comprising: determining a spatial distribution or fingerprint (e.g., a spatial error distribution or error fingerprint) of an apparatus parameter (e.g., an aberration parameter or stage performance parameter) across spatial coordinates on the substrate for each lithographic apparatus of said population of lithographic apparatuses and/or each layer of the plurality of layers; determining a reference distribution by aggregating each of said spatial error distributions to optimize said reference distribution such that a spatial distribution of a parameter of interest of said manufacturing process is co-optimized across said population of lithographic apparatuses and/or plurality of layers; and determining said setup correction and/or drift correction to correct said manufacturing process using said reference distribution as a target distribution for each scanner and/or layer.

The reference distribution may be common for all scanners and/or layers. The reference distribution may be optimized to minimize a parameter of interest error range (e.g., aberration range or position deviation range) of the scanner population and/or the plurality of layers.

The spatial distribution or fingerprint for each scanner or layer used to determine the reference distribution may comprise a spatial error distribution or error fingerprint, such as the residual fingerprint following a conventional setup procedure (e.g., conventional lens setup or grid setup). Alternatively, (in a lens setup context), the spatial distribution may be determined from population data of the lenses from the lens supplier.

The step of determining a reference distribution from each of said spatial distributions may comprise determining a weighted average of the spatial distributions. The optimization step may comprise determining weights per scanner/layer from which the weighted average is determined, the weights being determined to optimize the parameter of interest of the manufacturing process (e.g., to optimize a cost function related to or in terms of the parameter of interest). The parameter of interest may be, for example, overlay, edge placement error or any parameter indicative of yield (functioning of the integrated circuit). The weights of the individual scanner fingerprints may be determined iteratively till one or more criteria is/are reached, e.g., till the error range for the parameter of interest is minimized (e.g., max-absolute minimization, RMS minimization or any other suitable minimization) over the scanner population and/or all layers.

The co-optimization may also account for any specific sensitivities or weights which are specific to a particular application related to (e.g., to be performed by) one or more of said scanners/layers. Such domain specific sensitivities may describe the relationship between aberrations and the resulting pattern shifts, and may depend on the feature to be imaged and the corresponding illumination settings. Typically, in certain application domains (e.g. FEOL), similar types of features are exposed across different layers, with similar / complementary illumination settings. Hence the Zernike sensitivities can also be expected to be similar. An aberration ("Zernike") for which the sensitivity is low therefore contributes less to the "end result" (e.g., the pattern-shift), than a Zernike with overall high sensitivity. Hence it is less critical to optimize/minimize the Zernike with the lower sensitivity compared to the high sensitivity Zernike.

The reference distribution may be used as a target distribution for each scanner and/or layer during setup prior to commencing production and/or as a target for drift control during production.

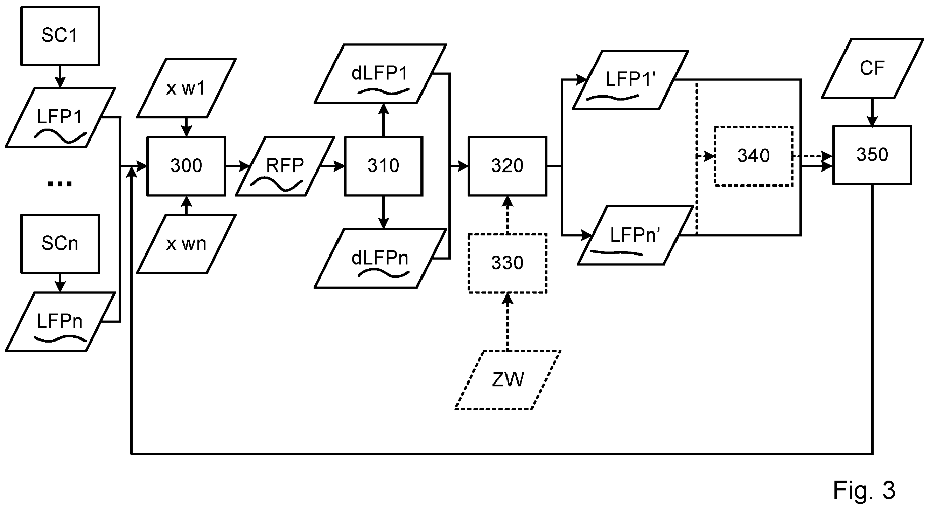

Figure 3 is a flow diagram illustrating the above concepts in a lens setup context. A population of scanners SC1...SCn each has a respective lens fingerprint LFP1...LFPn. The population of scanners may comprise two or more scanners to be used in a particular manufacturing process. Each fingerprint may be a residual fingerprint from a (e.g., conventional) lens setup operation. At step 300, a reference fingerprint RFP is determined from these fingerprints LFP1...LFPn. The reference fingerprint RFP may comprise an aggregation, or more specifically, a weighted average of the lens fingerprints (WALP) of the individual scanners. The weighting may be arbitrary for a first iteration and optimized over further iterations of this method till convergence. At step 310, the reference fingerprint RFP is subtracted from each of the individual scanner lens fingerprints LFP1...LFPn to obtain difference fingerprints dLFP1...dLFPn. At step 320, a further lens setup may be performed per scanner, using the difference fingerprints dLFP1...dLFPn as input, to obtain further residual lens fingerprints LFP1'...LFPn'. Optionally, this step may comprise an optimization of Zernike weights in the lens models (step 330) to account for the fact that within the application domain it may be more important to optimize certain, more critical, Zernikes, compared to others. Where Zernike weights are to be optimized (this step and/or the next step), these become additional parameters of the overall optimization in addition to the weights for the WALP.

At optional step 340, per scanner, the resulting residual lens fingerprints LFP1'...LFPn' may be combined with (e.g., multiplied by) domain specific sensitivities or any other applicable weights (e.g. all 1s), The domain specific sensitivities could be chosen such that they emphasize the most overlay critical aberrations for the given application domain, for example. This step, and the optional Zernike optimization in the previous step, may attribute more weight to certain aberrations ("Zernikes") in the lens model if they are deemed to be more important or critical, since then more actuation space can be given to the actuators to minimize these more important Zernikes. Of course, aberration sensitivities are not always known, or the application domain for certain scanners might be so broad that every Zernike is deemed to have similar importance. In this case each Zernike may be given fixed equal weight both in the lens model (step 330) and in the calculation of the cost function (step 340), in a similar manner to that presently done in the CLM.

At step 350, the residual lens fingerprints LFP1'...LFPn' (optionally combined with the sensitivities in the previous step) are summed and a suitable evaluation (e.g., according to a cost function) is performed. This may comprise, for example, a maxabs (or other suitable) minimization over all scanners (or any other applicable metric), which minimizes the error range of the residual lens fingerprints LFP1'...LFPn'. The steps 300 to 350 may be repeated iteratively to optimize the individual scanner fingerprints till convergence on a set of weights for the WALP which minimize the maxabs (or other suitable evaluation) of the cost function over the scanner population.

In a specific example where sensitivities are taken into account, an individual scanner LFP may comprise a 13 x 64 matrix; i.e., 13 positions in the exposure slit, 64 Zernikes. This LFP may be matrix multiplied by 64 Zernike sensitivities to yield a pattern-shift for 13 positions in the slit. This may be performed for every scanner. The WALP is then the weighted average of this pattern-shift over all scanners. Alternatively a weighted average of the 13x64 lens fingerprints may be calculated first and then matrix multiplied with the 64 row sensitivity vector.

To implement such a method, the cost function may take the form, by way of a specific example:

$$WALP = \frac{\sum_i w_i \cdot LFP_i}{\sum_i w_i}$$

$$f(w_i) = \max_i(|LFP_i - WALP(w_i)|)$$

which may be minimized in terms of the weights $w_i$ ($i$ is the scanner (or layer) index: $i = 1$ to $n$). A mapping function can be defined which maps the individual weighted fingerprints $w_i \cdot LFP_i$ to the reference fingerprint or WALP. This reference fingerprint/WALP can be used in a further lens setup per scanner to obtain a cost (using the cost function), which is fed back to the mapping function iteratively till convergence. This is only a specific example of a cost function, other cost functions may be used, e.g., which also take into account specific sensitivities and/or related additional optimization of Zernike weights supplied to the CLM as has been described.

The optimization may make use of standard (e.g. gradient descent based) optimizers, or if there is a large number of parameters to be optimized in parallel (e.g. weights per slit position and Zernike weights in the lens setup), an evolutionary algorithm (e.g., a genetic algorithm) based optimization may be used.

The philosophy behind this approach is that it is sometimes better for the setup operation to minimize towards a non-zero reference rather than zero (i.e., to aim to eliminate all errors/aberrations/deviations). If this reference fingerprint is common for all scanners and configured to minimize the aberration range of the population, then the overall performance (e.g., in terms of MMO) over all applicable scanner combinations may be improved (e.g., MMO minimized) for the given application domain (e.g., also taking into account the application domain specific criticality of certain aberrations, errors and/or layers).

In a lens setup context, the weights to be optimized may comprise weights per position in the exposure slit, and optionally the Zernike weights for the lens setup (e.g., the CLM). The cost function might further receive Zernike sensitivities to make it more application domain specific.

The algorithm may be run offline (e.g., on a server) for calibration or training, with the reference distribution (e.g., WALP) used by the individual scanners for control. This calibration may be repeated / updated at regular intervals in order to account for drifts (e.g., lens drifts or positional drifts). The algorithm may be extended to comprise weights per slit position, constraints on the reference distribution (e.g., to minimize collateral impact on MMO), and/or to co-optimize the weights of the individual (dynamic) Zernikes in the lens model for further optimization towards the application domain (which may further reduce the relevant aberration ranges).

While the specific embodiment described has been provided in the context of lens setup and/or lens drift control, the concepts may be used for other setup or drift control operations such as grid setup or drift control. As such, any mention of lens fingerprints in the above text may equally apply to position deviation fingerprints (maps which describe spatial variation of position deviation) in a grid setup context, so as to determine a reference position deviation fingerprint. This reference position deviation fingerprint may be a weighted average (or other mapping function) of individual position deviation fingerprints, so as to determine corrections for an expose trajectory (wafer stage and/or reticle stage control/actuation), although correction may also use lens actuation.

Further embodiments of the invention are disclosed in the list of numbered clauses below:

1. A method for performing a lithographic apparatus setup calibration and/or drift correction for a specific lithographic apparatus of a population of lithographic apparatuses to be used in a manufacturing process for manufacturing an integrated circuit extending across a plurality of layers on a substrate, the method comprising:

determining a spatial error distribution of an apparatus parameter across spatial coordinates on the substrate for each lithographic apparatus of said population of lithographic apparatuses and/or each layer of the plurality of layers;

determining a reference distribution by aggregating each of said spatial error distributions to optimize said reference distribution such that a spatial distribution of a parameter of interest of said manufacturing process is co-optimized across said population of lithographic apparatuses and/or plurality of layers; and

using said reference distribution as a target distribution for said apparatus parameter for each lithographic apparatus and/or layer.

2. A method according to clause 1, wherein said reference distribution is common for all lithographic apparatuses and/or layers.

3. A method according to clause 1 or 2, wherein said reference distribution is optimized to minimize an error range of the apparatus parameter across the lithographic apparatus population and/or the plurality of layers.

4. A method according to any preceding clause, wherein the spatial error distribution for each lithographic apparatus or layer used to determine the reference distribution comprises a residual error fingerprint following an initial or simulated setup procedure.

5. A method according to any preceding clause, wherein said aggregating comprises performing a weighted average of said spatial error distributions.

6. A method according to clause 5, wherein said optimizing of the reference distribution comprises determining weights per lithographic apparatus and/or layer for the weighted average, the weights being determined to optimize the parameter of interest of the manufacturing process.

7. A method according to clause 6 wherein said determining a reference distribution comprises performing an iterative optimization of said weights till at least one convergence criterion is met.

8. A method according to clause 6 or 7, wherein the step of aggregating comprises determining a mapping function which maps said spatial error distributions weighted by respective said weights to said weighted average of said spatial error distributions.

9. A method according to any preceding clause, wherein said parameter of interest is overlay, edge placement error or any parameter indicative of yield.

10. A method according to any preceding clause, wherein said step of determining a reference distribution accounts for at least one sensitivity or weight specific to a particular application related to one or more of said lithographic apparatuses and/or layers and/or said integrated circuit.

11. A method according to any preceding clause, wherein said reference distribution is used as a target distribution for each lithographic apparatus and/or layer during a setup or calibration operation prior to commencing production.

12. A method according to any preceding clause, wherein said reference distribution is used as a target distribution for drift control during production, such that any drift is corrected towards said target distribution.

13. A method according to any preceding clause, wherein the apparatus parameter is aberration of projection system of a lithographic apparatus, and said setup comprises a lens setup for calibrating the projection system.

14. A method according to clause 13, wherein said step of determining a reference distribution further comprises an optimization of aberration or Zernike weights in a lens model used in said lens setup.

15. A method according to clause 14, wherein said optimization of aberration or Zernike weights comprises attributing a weighting to one or more aberrations or Zernikes based on a particular application related to one or more of said lithographic apparatuses and/or layers and/or said integrated circuit.

16. A method according to clause 13, 14 or 15, wherein each said spatial error distribution comprises a lens fingerprint describing lens aberrations per position of an exposure slit.

17. A method according to any of clauses 1 to 12, wherein the apparatus parameter is position deviation in one or both of a reticle stage and substrate stage of the lithographic apparatus and said setup comprises a grid setup for calibrating a measure and/or exposure grid.

18. A method according to clause 17, wherein each said spatial error distribution comprises a position deviation fingerprint.

19. A method according to any preceding clause, comprising performing said method for each lithographic apparatus of said population.

20. A computer program comprising program instructions operable to perform the method of any preceding clause, when run on a suitable apparatus.

21. A non-transient computer program carrier comprising the computer program of clause 20.

22. A processing arrangement comprising:

> a computer program carrier comprising the computer program of clause 20; and
> a processor operable to run said computer program.

23. A lithographic apparatus comprising the processing arrangement of clause 22

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1. A method for performing a lithographic apparatus setup calibration and/or drift correction for a specific lithographic apparatus of a population of lithographic apparatuses to be used in a manufacturing process for manufacturing an integrated circuit extending across a plurality of layers on a substrate, the method comprising:

   determining a spatial error distribution of an apparatus parameter across spatial coordinates on the substrate for each lithographic apparatus of said population of lithographic apparatuses and/or each layer of the plurality of layers;
   determining a reference distribution by aggregating each of said spatial error distributions to optimize said reference distribution such that a spatial distribution of a parameter of interest of said manufacturing process is co-optimized across said population of lithographic apparatuses and/or plurality of layers; and
   using said reference distribution as a target distribution for said apparatus parameter for each lithographic apparatus and/or layer.

2. A method as claimed in claim 1, wherein said reference distribution is common for all lithographic apparatuses and/or layers.

3. A method as claimed in claim 1 or 2, wherein said reference distribution is optimized to minimize an error range of the apparatus parameter across the lithographic apparatus population and/or the plurality of layers.

4. A method as claimed in any preceding claim, wherein the spatial error distribution for each lithographic apparatus or layer used to determine the reference distribution comprises a residual error fingerprint following an initial or simulated setup procedure.

5. A method as claimed in any preceding claim, wherein said aggregating comprises performing a weighted average of said spatial error distributions.

6. A method as claimed in claim 5, wherein said optimizing of the reference distribution comprises determining weights per lithographic apparatus and/or layer for the weighted average, the weights being determined to optimize the parameter of interest of the manufacturing process.

7. A method as claimed in claim 6 wherein said determining a reference distribution comprises performing an iterative optimization of said weights till at least one convergence criterion is met.

8. A method as claimed in claim 6 or 7, wherein the step of aggregating comprises determining a mapping function which maps said spatial error distributions weighted by respective said weights to said weighted average of said spatial error distributions.

9. A method as claimed in any preceding claim, wherein said parameter of interest is overlay, edge placement error or any parameter indicative of yield.

10. A method as claimed in any preceding claim, wherein said step of determining a reference distribution accounts for at least one sensitivity or weight specific to a particular application related to one or more of said lithographic apparatuses and/or layers and/or said integrated circuit.

11. A method as claimed in any preceding claim, wherein said reference distribution is used as a target distribution for each lithographic apparatus and/or layer during a setup or calibration operation prior to commencing production.

12. A method as claimed in any preceding claim, wherein said reference distribution is used as a target distribution for drift control during production, such that any drift is corrected towards said target distribution.

13. A method as claimed in any preceding claim, wherein the apparatus parameter is aberration of projection system of a lithographic apparatus, and said setup comprises a lens setup for calibrating the projection system.

14. A method as claimed in claim 13, wherein said step of determining a reference distribution further comprises an optimization of aberration or Zernike weights in a lens model used in said lens setup.

15. A method as claimed in any of claims 1 to 12, wherein the apparatus parameter is position deviation in one or both of a reticle stage and substrate stage of the lithographic apparatus and said setup comprises a grid setup for calibrating a measure and/or exposure grid.

Fig. 1

Fig. 2

Fig. 3

Europäisches
Patentamt

European
Patent Office

Office européen
des brevets

# EUROPEAN SEARCH REPORT

Application Number

EP 22 16 3435

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2020/272059 A1 (FRISCO PIERLUIGI [NL] ET AL) 27 August 2020 (2020-08-27)<br>* abstract *<br>* figure 1 *<br>* paragraphs [0002], [0007], [0008], [0017], [0021], [0066] – [0119] * | 1-4,9, 11-15<br>5-8 | INV.<br>G03F7/20 |
| A | WO 2021/160351 A1 (ASML NETHERLANDS BV [NL]) 19 August 2021 (2021-08-19)<br>* abstract *<br>* figure 1 *<br>* paragraphs [0002], [0058] * | 1-15 | |
| A | WO 2021/160380 A1 (ASML NETHERLANDS BV [NL]) 19 August 2021 (2021-08-19)<br>* abstract *<br>* figure 1 *<br>* paragraphs [0002], [0006], [0045], [0057] * | 1-15 | |
| A | EP 3 796 087 A1 (ASML NETHERLANDS BV [NL]) 24 March 2021 (2021-03-24)<br>* abstract *<br>* figure 1 *<br>* paragraphs [0001], [0037], [0046] * | 1-15 | TECHNICAL FIELDS SEARCHED (IPC)<br><br>G03F |

The present search report has been drawn up for all claims

| Place of search | Date of completion of the search | Examiner |
|---|---|---|
| Munich | 30 August 2022 | Andersen, Ole |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 ...................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 22 16 3435

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2022

| Patent document cited in search report | | Publication date | Patent family member(s) | | Publication date |
|---|---|---|---|---|---|
| US 2020272059 | A1 | 27-08-2020 | CN | 111095109 A | 01-05-2020 |
| | | | NL | 2021465 A | 11-03-2019 |
| | | | US | 2020272059 A1 | 27-08-2020 |
| | | | WO | 2019042757 A1 | 07-03-2019 |
| WO 2021160351 | A1 | 19-08-2021 | TW | 202132905 A | 01-09-2021 |
| | | | WO | 2021160351 A1 | 19-08-2021 |
| WO 2021160380 | A1 | 19-08-2021 | TW | 202144925 A | 01-12-2021 |
| | | | WO | 2021160380 A1 | 19-08-2021 |
| EP 3796087 | A1 | 24-03-2021 | NONE | | |

EPO FORM P0459

For more details about this annex : see Official Journal of the European Patent Office, No. 12/82